(19) Europäisches Patentamt
European Patent Office
Office européen des brevets

(11) EP 4 332 595 B1

(12) **EUROPEAN PATENT SPECIFICATION**

(45) Date of publication and mention
of the grant of the patent:
**14.05.2025 Bulletin 2025/20**

(21) Application number: **22214164.0**

(22) Date of filing: **16.12.2022**

(51) International Patent Classification (IPC):
**G01R 31/382** (2019.01)

(52) Cooperative Patent Classification (CPC):
**G01R 31/382; B60L 58/12;** B60L 2240/545;
B60L 2240/547; B60L 2240/549; G01R 31/007;
G01R 31/367; G01R 31/396

(54) **METHOD AND DEVICE FOR CALCULATING STATE OF CHARGE, VEHICLE AND STORAGE MEDIUM**

VERFAHREN UND VORRICHTUNG ZUR BERECHNUNG DES LADEZUSTANDS, FAHRZEUG UND SPEICHERMEDIUM

PROCÉDÉ ET DISPOSITIF DE CALCUL D'ÉTAT DE CHARGE, VÉHICULE ET SUPPORT D'INFORMATIONS

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **31.08.2022 CN 202211065495**

(43) Date of publication of application:
**06.03.2024 Bulletin 2024/10**

(73) Proprietor: **Guangzhou Xiaopeng Motors Technology Co., Ltd.**
**Guangzhou, Guangdong 510000 (CN)**

(72) Inventor: **ZHAN, Di**
**Guangzhou, 510000 (CN)**

(74) Representative: **Ran, Handong et al**
**Maucher Jenkins**
**Seventh Floor Offices**
**Artillery House**
**11-19 Artillery Row**
**London SW1P 1RT (GB)**

(56) References cited:
EP-A1- 3 828 568        CN-A- 111 220 922
DE-T5- 112016 006 166   US-A1- 2015 081 237
US-A1- 2017 016 961     US-A1- 2018 143 258
US-A1- 2021 249 885

- ZHONG LIANG ET AL: "A method for the estimation of the battery pack state of charge based on in-pack cells uniformity analysis", APPLIED ENERGY, ELSEVIER SCIENCE PUBLISHERS, GB, vol. 113, 28 August 2013 (2013-08-28), pages 558 - 564, XP028762977, ISSN: 0306-2619, DOI: 10.1016/J.APENERGY.2013.08.008
- HU LIN ET AL: "Reliable state of charge estimation of battery packs using fuzzy adaptive federated filtering", APPLIED ENERGY, ELSEVIER SCIENCE PUBLISHERS, GB, vol. 262, 3 February 2020 (2020-02-03), XP086067994, ISSN: 0306-2619, [retrieved on 20200203], DOI: 10.1016/J.APENERGY.2020.114569

## Description

**Technical Field**

The present disclosure relates to the field of power battery technology, and in particular to a method, and a device for calculating state of charge, a vehicle, and a storage medium.

**Background**

A Battery Management System (BMS) plays a critical role in guaranteeing the safety and operational performance of an electric vehicle and has become the core technology in the research and development of electric vehicles. Estimating the state of charge (SOC) of a battery pack is one of the difficulties in developing BMS.

In related technologies, SOC is usually estimated using an algorithm combining an ampere-hour integration method and an open circuit voltage (OCV) method. The ampere-hour integration method is a basic approach for calculating SOC based on the definition of quantity of electric charge, which integrates the electric current for the calculation. However, the precision of the ampere-hour integration method is highly dependent on the precision of SOC and that of the sensor. Once an error is produced, it will accumulate with time and cannot be eliminated. In view of this, the open circuit voltage method is further performed to correct the results of the ampere-hour integration method based on the linear relation between OCV and SOC. This method measures fully settled voltage of the battery and looks up a relation table to acquire an SOC value, which is used as the corrected value. This improves the precision of SOC estimation to some extent.

Unlike a ternary battery, in an OCV curve of a lithium iron phosphate battery, when the SOC is in the range of 30%-55% and in the range of 65%-99% (i.e., platform zones), the OCV changes slightly with the SOC and the amplitude of the OCV change cannot be detected by existing voltage sampling equipment. In this case, the SOC can be corrected using the OCV method only within the limited non-platform zones. However, the lithium iron phosphate battery is characterized by distinct hysteresis of voltage as well as slow depolarization. Therefore, under the impact of previous operating conditions of charge and discharge of the battery, the OCV measurement error may be up to 20mV. A great OCV measurement error will result in a significant error in the corrected value of the SOC obtained by looking up the table. This may cause a false correction of the SOC and the SOC for the battery pack calculated in this way is incorrect.

EP 3 828 568 A1 discloses a battery management apparatus, a battery management method and a battery pack. The battery management apparatus includes a sensing unit configured to detect a current, a voltage and a temperature of a battery, and a control unit configured to determine a first candidate value for a state of charge (SOC) of the battery using ampere counting. The control unit determines a Kalman gain and a second candidate value for the SOC using an extended Kalman filter. The control unit determines the first candidate value as the SOC when a difference value between the first candidate value and the second candidate value is larger than a threshold value. The control unit adjusts a ratio of second process noise to first process noise in the extended Kalman filter based on a first component and a second component of the Kalman gain.

**Summary**

The embodiments of the present disclosure provide a method and a device for calculating the state of charge, a vehicle, and a storage medium. The invention is set out in the appended set of claims.

**Brief Description of Drawings**

To illustrate the technical solutions of the examples of the present disclosure more clearly, the accompanying drawings needed for describing the examples will be explained briefly. Evidently, the following accompanying drawings only illustrate some of the embodiments of the present disclosure, and other drawings can be obtained by those skilled in the art according to these drawings without contributing creative work.

Fig. 1 is a schematic diagram of a vehicle according to an example of the present disclosure;
Fig. 2 is a schematic flowchart of a method for calculating a state of charge according to a first example of the present disclosure;
Fig. 3 is a schematic flowchart of a method for calculating a state of charge according to a second example of the present disclosure;
Fig. 4 is a schematic flowchart of a method for calculating a state of charge according to a third example of the present disclosure;
Fig. 5 is a module block diagram of a device for calculating a state of charge according to an example of the present disclosure;
Fig. 6 is a module block diagram of the vehicle according to an example of the present disclosure;
Fig. 7 is a module block diagram of a computer-readable storage medium according to an example of the present disclosure.

**Detailed Description**

The following will describe and illustrate the embodiments of the present disclosure with reference to the accompanying drawings. The same or similar reference signs indicate the same or similar elements or elements with the same or similar functions. The embodiments described according to the accompanying drawings are only exemplary for explaining the present disclosure, which cannot be construed as limiting the present disclosure.

To make it easier for those skilled in the art to understand the technical solutions of the present disclosure, the technical solutions will be described clearly and completely with reference to the accompanying drawings. The embodiments described below are only a part of the embodiments in the present disclosure rather than all embodiments. Any other embodiments acquired by ordinary persons skilled in the art based on the embodiments in the present disclosure without creative work all fall within the scope of the present disclosure.

The embodiments of the present disclosure provide a method and a device for calculating a state of charge, a vehicle, and a storage medium. The method is applied to a battery pack containing a battery cell. The method acquires a first state of charge of the battery cell determined based on a preset integration algorithm and a second state of charge of the battery cell determined based on a preset filter algorithm, and then determines the second state of charge as a target state of charge of the battery cell if the charge information (i.e., the first state of charge and the second state of charge of the battery cell) satisfies specified precision judging criteria. That is, the second state of charge of the battery cell is then used to calculate the total state of charge of the battery pack. In addition, if the charge information fails to satisfy the specified precision judging criteria, the first state of charge is determined as the target state of charge of the battery cells.

When the charge information satisfies the specified precision judging criteria, the total state of charge of the battery pack calculated on the basis of the second state of charge is more accurate than that calculated on the basis of the first state of charge. Thus, the vehicle may achieve a more accurate estimation of the total state of charge of the battery pack, thereby facilitating a driver's precise control in connection with the real-time SOC of the battery pack while traveling.

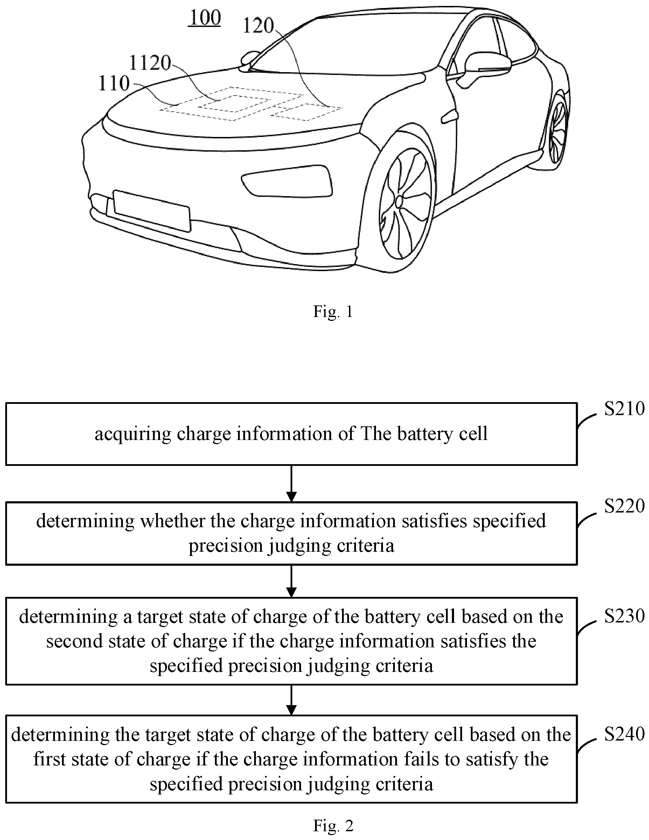

To describe the technical solutions of the present disclosure in detail, the application environment of the embodiments of the present disclosure will be introduced with reference to the accompanying drawings. Referring to Fig. 1, a method for calculating a state of charge according to an embodiment of the present disclosure is applied to a vehicle 100. The vehicle 100 refers to a vehicle for passengers or freight driven or pulled by a power unit, which includes but not limited to a car, minibus, bus, etc. Specifically, the vehicle 100 includes a battery pack 110 and a processor 120.

The battery pack 110 provides a driving force for vehicle 100. Taking a new energy vehicle as an example of vehicle 100, the battery pack 110 provides a driving force for the new energy vehicle and mobilizes the driving system (such as axles and wheels) through a transmission system. The battery pack 110 according to an embodiment of the present disclosure includes a plurality of battery cells 1120, which constitute the battery pack 110 by connecting with each other in series or parallel connections. Specifically, battery cells 1120 may be lithium battery cells, nickel metal hydride battery cells, or lithium iron phosphate battery cells, etc. The specific type and connection of battery cells 1120 are not limited thereto.

According to an embodiment of the present disclosure, the battery pack 110 further includes a plurality of detectors for acquiring measuring data of the battery cells 1120, such as the electric current, the voltage, and the temperature. Specifically, the detectors may include a current sensor (such as a current transformer, a Hall current sensor, and a flux gate current sensor), a voltage sensor (such as a Hall voltage sensor and an optical fiber voltage sensor), and a temperature sensor (such as a platinum resistance thermometer sensor, a thermocouple temperature sensor, and a thermistor temperature sensor), etc. The present disclosure does not have any limitation to the specific implementation of the detectors.

The processor 120 is a processing unit with functions of reading and processing data. According to an embodiment of the present disclosure, the processor 120 is electrically connected to the battery pack 110. Specifically, the processor 120 is electrically connected to the plurality of detectors in the battery pack 110 to acquire the measuring data of the plurality of battery cells 1120. Further, the measuring data is used in turn in determining the total state of charge of the battery pack 110. Specifically, the method of determining the total state of charge of the battery pack 110 will be described in detail in below embodiments.

It should be noted that the application environment of the method for calculating the state of charge provided herein is only exemplary. The method may be further applied to other vehicle, electrical equipment, or electronic equipment having a battery pack, but is not limited thereto.

Referring to Fig. 2, Fig. 2 schematically shows the method for calculating the state of charge of the battery pack according to a first example of the present disclosure. The method is applied to the battery pack containing the battery cells. Specifically, the method includes steps S210 to S240.

At step S210, charge information of the battery cells is acquired.

According to the embodiment, the charge information includes the first state of charge and the second state of charge of the battery cells. The first state of charge is determined based on the preset integration algorithm. As an example, the first state of charge may be calculated by a first data processing module corresponding to the battery pack. The processor can directly read the calculation result from the first data processing module. As another example, the processor acquires the measuring data of the battery cells and determines the first state of charge using the preset integration algorithm.

The calculation here is described to be performed by the processor, for example. The processor may calculate the first state of charge based on the current in the battery cells. For example, the processor acquires an actual current value of the battery cells within the current sampling period and performs an integration on the actual current value using the preset integration algorithm, to obtain the first state of charge of the battery cells. Specifically, the duration of the sampling period may be a default value in the processor, or may be adjusted by the processor based on update frequency of the state of charge, wherein the duration of the sampling period is in a negative correlation to the update frequency, that is, the higher the update frequency of the state of charge of the battery, the shorter the duration of the sampling period.

The preset integration algorithm may be an ampere-hour integration method, which uses the following formula:

$$SOC_1 = SOC_0 - \frac{1}{C} \int_0^t \eta * I dt$$

wherein $SOC_1$ is the first state of charge, $SOC_0$ is the initial state of charge of the battery cells corresponding to the value of the state of charge at the founding moment (i.e., t = 0) of the integration algorithm. As an example, the founding moment of the integration algorithm may be the moment when the vehicle powers on. The processor obtains the value of the state of charge of the battery cells at that moment and uses the value as the initial state of charge. $C$ is the nominal capacity of the battery cells, $t$ is the current moment, $\eta$ is the charge-discharge efficiency of the battery cells, and $I$ is the actual electric current value of the battery cells corresponding to the current moment. The nominal capacity and the charge-discharge efficiency are default parameters of the battery cells that can be determined by the processor by reading relevant parameter information from the battery cells.

In the embodiment, the second state of charge is determined based on the preset filter algorithm.

As an example, the second state of charge may be calculated by a second data processing module corresponding to the battery pack. The processor can directly read the calculation result from the second data processing module. As another example, the processor acquires the measuring data of the battery cells and determines the second state of charge based on the preset filter algorithm.

The calculation here is described to be performed by the processor, for example. The processor may calculate the second state of charge based on the electric current and the voltage in the battery cells. For example, the processor acquires the actual electric current value and the actual voltage value of the battery cells within the current sampling period and performs a filtering on the actual electric current value and the actual voltage value using the preset filter algorithm, to obtain the second state of charge of the battery cells. Specifically, the first state of charge and the second state of charge may be acquired simultaneously, or the processor may determine the first state of charge, and then obtain the second state of charge. The order of acquiring the first state of charge and the second of charge is not limited thereto. The preset filter algorithm may be the Kalman Filter algorithm, which performs an optimal estimate of the state of a system using observed inputs into and outputs from the system based on a linear system state equation. In the embodiment, the observed data of the system inputs and outputs are actual electric current values and actual voltage values of the battery cells and the system's sate is the second state of charge of the battery cells. Specifically, the Kalman Filter algorithm may be expressed as follows:

$$\begin{cases} X(k) = A * X(k-1) + B * U(k) + W \\ Y(k) = C * X(k-1) + D * U(k) + V \end{cases}$$

$X(k)$ is a matrix of state variable. In the embodiment, the second state of charge is a parameter in the matrix of state variable. $U(k)$ is a matrix of input variables, i.e., the actual electric current values of the battery cells. $W$ is a matrix of process noise. $Y(k)$ is a matrix of output variable, i.e., the actual voltage values of the battery cells. $V$ is a measurement noise matrix. Specifically, $W$ and $V$ can be used to determine the noise measurement corresponding to the battery pack. $A$, $B$, $C$, and $D$ are known quantities and equivalent circuit model can be applied to perform estimation on the battery cells. $k$ is the moment corresponding to the current sampling period, k - 1 is the moment corresponding to the last sampling period. That is, the processor updates the matrix of state variable $X(k - 1)$ of the last period, to obtain $X(k)$ of the current sampling period, i.e., the second state of charge.

Specifically, the Kalman Filter algorithm may be the Extended Kalman Filter (EKF) algorithm, the Unscented Kalman Filter (UKF) algorithm, or the like. The specific implementation of the Kalman Filter algorithm is not limited thereto.

At step S220, a determination is made as to whether the charge information satisfies specified precision judging criteria.

The specified precision judging criteria at least include that the second state of charge satisfies a preset first SOC range. The preset first SOC range may be a value range. If the value of the second state of charge is within the value range, it means that the second state of charge satisfies the preset first SOC range. Otherwise, if the value of the second state of charge is not within the value range, it means that the second state of charge does not satisfy the preset first SOC range. For example, the value range corresponding to the first SOC range may be $[SOC_{CLA,min}, SOC_{CLA,max}]$, wherein the processor may adjust the lower limit $SOC_{CLA,min}$ and the upper limit

$SOC_{CLA,max}$ dynamically based on the actual operating condition of the vehicle.

As an example, the processor determines the value range corresponding to the first SOC range by acquiring the value of an operating condition indicator of the vehicle and based on a mapping table for the preset first SOC range. The mapping table for the preset first SOC range expresses the corresponding relation between values of the operating condition indicator and value ranges corresponding to the first SOC range. Specifically, the mapping table for the preset first SOC range may be obtained by the R&D personnel based on large amount of test data of the operating conditions of vehicles. The specific implementation of the mapping table for the preset first SOC range is not limited thereto.

When the charge information satisfies the specified precision judging criteria, the total state of charge of the battery pack calculated on the basis of the second state of charge is more accurate than that calculated on the basis of the first state of charge. Thus, the processor may achieve a more accurate estimation of the total state of charge of the battery pack. Specifically, R&D personnel found that the total state of charge of the battery pack can be calculated on the basis of the second state of charge with an accuracy more than 97%, facilitating a precise control by the driver in connection with the real-time SOC of the battery pack while traveling and improving the driving experience of the driver.

At step S230, if the charge information satisfies the specified precision judging criteria, a target state of charge of the battery cells is determined based on the second state of charge.

The target state of charge is used as the basis for calculating the total state of charge of the battery pack. As an example, when the charge information satisfies the specified precision judging criteria, the processor sends the second state of charge as the target state of charge of the battery cells to a total state of charge calculation module, which calculates the total state of charge of the battery pack based on the second state of charge. As another example, when the charge information satisfies the specified precision judging criteria, the processor directly uses the second state of charge as the target state of charge of the battery cells and calculates the total state of charge of the battery pack. The processor is introduced herein as an example for performing the calculation. As an example, the processor stores weights corresponding to the target state of charge and determines the total state of charge of the battery pack to be the product of the target state of charge multiplying the weight.

It should be noted that when the second state of charge of the battery cells has been calculated by the Kalman Filter algorithm within the current sampling period, in step S210, the processor will update the matrix of state variable $X(k)$ in the Kalman Filter algorithm. If the charge information satisfies the specified precision judging criteria, the processor will further update an error covariance matrix, thereby using the updated error covariance matrix $P(k)$ and the matrix of state variable $X(k)$ as relevant parameters in the Kalman Filter algorithm in the next sampling period, thus completing the iteration of the Kalman Filter algorithm. Specifically, the error covariance matrix $P(k)$ can be calculated according to the following formula:

$$P(k) = (\mathrm{I} - \mathrm{K} * \mathrm{C})P(k)'$$

wherein $P(k)$ is the error covariance matrix, I is the identity matrix, K is the Kalman gain, $P(k)'$ is the transposed matrix of $P(k)$.

At step S240, if the charge information fails to satisfy the specified precision judging criteria, the target state of charge of the battery cells is determined based on the first state of charge.

The charge information not satisfying the specified precision judging criteria means that there is significant measurement error in the second state of charge. To make sure the total state of charge of the battery pack is accurately calculated, the processor determines the target state of charge of the battery cells based on the first state of charge and calculates the total state of charge of the battery pack based on the first state of charge in subsequent processes.

It should be noted that when the charge information fails to satisfy the specified precision judging criteria, the processor initializes the matrix of state variable $X(k)$ and the error covariance matrix $P(k)$ and uses the initialized matrix of state variable $X(0)$ and the initialized error covariance matrix $P(0)$ as relevant parameters in the Kalman Filter algorithm in the next sampling period. That is, in the next sampling period, the processor will acquire the actual electric current and the actual voltage of the battery cells within the sampling period and calculates the second state of charge in the next sampling period based on $X(0)$ and $P(0)$. Specifically, $X(0)$ and $P(0)$ are default parameters in the processor. If the charge information fails to satisfy the specified precision judging criteria, there would be significant errors in the corresponding matrices after $X(k)$ and $P(k)$ are updated. At this time, the processor can eliminate the errors by initializing $X(k)$ and $P(k)$ separately, thereby guaranteeing accurate calculation of the second state of charge.

The present disclosure provides a method for calculating the state of charge. The method acquires the first state of charge of the battery cells determined based on the preset integration algorithm and the second state of charge of the battery cells determined based on the preset filter algorithm, and then determines the second state of charge as the target state of charge of the battery cells if the charge information (i.e., the first state of charge and the second state of charge of the battery cells) satisfies the specified precision judging criteria. That is, the total state of charge of the battery pack is calculated based on the second state of charge of the battery cells. In addition, if the charge information fails to satisfy the specified precision judging criteria, the first state of charge is determined as the target state of charge of the battery cells.

When the charge information satisfies the specified precision judging criteria, the total state of charge of the battery pack calculated on the basis of the second state of charge is more accurate than that calculated on the basis of the first state of charge. Thus, the vehicle can achieve a more accurate estimation of the total state of charge of the battery pack, thereby facilitating a driver's precise control in connection with the real-time SOC of the battery pack while traveling.

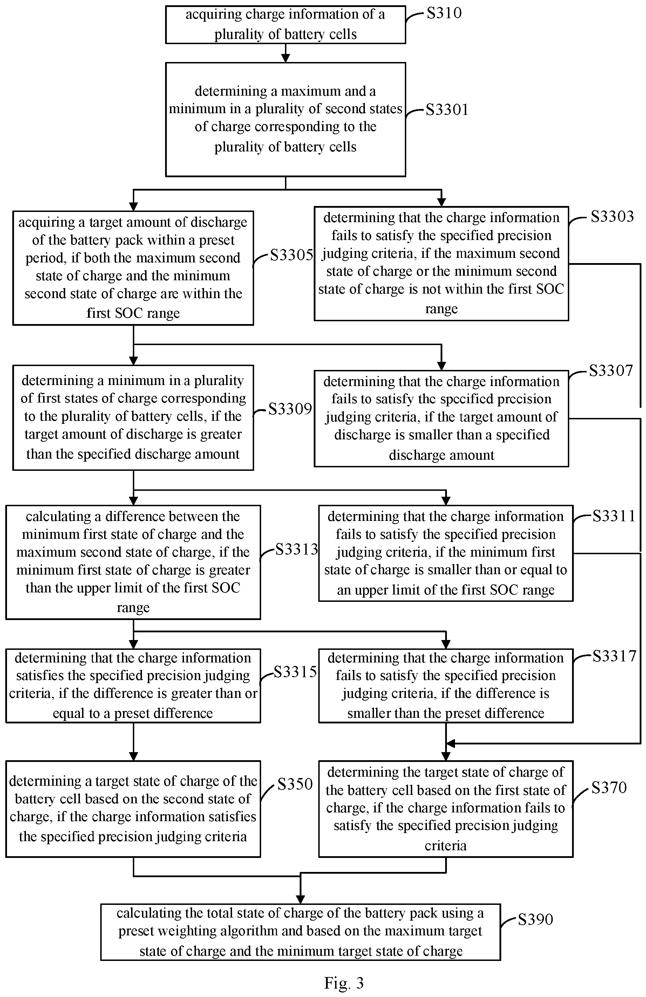

Referring to Fig. 3, Fig. 3 schematically shows the method for calculating a state of charge according to the second embodiment of the present disclosure. The method is applied to a battery pack containing a plurality of battery cells. The method elaborates the specified precision judging criteria in the above-mentioned embodiments. Specifically, the method further includes steps S310-S370.

At step S310, charge information of a plurality of battery cells is acquired.

The plurality of battery cells according to the embodiment may be all of the battery cells in the battery pack or part of the battery cells in the battery pack. As an example, the processor randomly selects a specified number of battery cells among all the battery cells and acquires first states of charge and second states of charge corresponding to the specified number of battery cells. The specified number is smaller than the total number of battery cells and may be a default value in the processor. The processor may adjust the specified number based on current computing resources, that is, the more the current computing resources, the greater the specified number. Reference may be made to the description of step S210 for details of the steps of acquiring the first states of charge and the second states of charge, which will not be repeated. Since the processor only determines charge information of some of the battery cells, the calculating speed of the processor can be accelerated, thereby making sure the total state of charge of the battery pack can be updated in time.

At step S330, if the charge information satisfies the specified precision judging criteria, the target state of charge of the battery cells is determined based on the second state of charge.

After the processor acquires the charge information, it further determines whether the charge information satisfies the specified precision judging criteria. After a result of the determination is obtained, the processor can determine the target state of charge of the battery cells, so that the estimation of the total state of charge of the battery pack can be more accurate. In the embodiment, the specified precision judging criteria may include the following four criteria:

1. The second states of charge of respective plurality of battery cells satisfy the preset first SOC range;
2. If criterion 1 is satisfied, a target amount of discharge of the battery pack within a preset period is greater than or equal to a specified discharge amount;
3. The first states of charge corresponding to the respective plurality of battery cells are greater than the second states of charge corresponding to the respective plurality of battery cells;
4. If criterion 3 is satisfied, the difference between any of the first states of charge and any of the second states of charge is greater than or equal to a preset difference.

If the processor determines that the above four criteria are all satisfied, it determines that the charge information satisfies the specified precision judging criteria. Otherwise, if the processor determines that at least one of the above four criteria is not satisfied, it determines that the charge information fails to satisfy the specified precision judging criteria. Specifically, determining by the processor whether the charge information satisfies the specified precision judging criteria includes the following steps S3301 to 3317.

At step S3301, the maximum second state of charge and the minimum second state of charge in the plurality of second states of charge corresponding to the plurality of battery cells are determined.

As an example, the processor sorts the plurality of second states of charge corresponding to the plurality of battery cells using a preset sort algorithm, and determines the greatest one of the plurality of second states of charge as the maximum second state of charge and the smallest one of the plurality of second states of charge as the minimum second state of charge. Specifically, the preset sort algorithm may be a selection sort algorithm, a bubble sort algorithm, or a sort-by-insertion algorithm, which will not be limited thereto.

At step S3303, if the maximum second state of charge or the minimum second state of charge is not within the first SOC range, it is determined that the charge information fails to satisfy the specified precision judging criteria.

For details of the first SOC range, reference can be made to the introduction of step S220. It should be noted that the first SOC range according to the embodiment is expressed as a value range of $[SOC_{CLA,min}, SOC_{CLA,max}]$. The value range is acquired by the inventor based on large quantity of test data of battery packs. If the plurality of second states of charge are within the value range, the second states of charge calculated by the Kalman Filter algorithm are more accurate. Otherwise, if there is a second state of charge outside the value range, a certain error may present in the second states of charge calculated. As a result, the second states of charge cannot be used to estimate the total state of charge of the battery pack.

Specifically, if the maximum second state of charge or the minimum second state of charge does not satisfy the first SOC range, i.e., $SOC_{2,max} \notin [SOC_{CLA,min}, SOC_{CLA,max}]$ or $SOC_{2,min} \notin [SOC_{CLA,min}, SOC_{CLA,max}]$, the processor determines that the charge information fails to satisfy the specified precision judging criteria. Here, $SOC_{2,max}$ is the maximum second state of charge and $SOC_{2,min}$ is the minimum second state of charge. In the embodiment, if the charge information fails to satisfy the specified precision judging criteria (i.e., the above-mentioned criterion 1), the processor proceeds to step S370. Otherwise, if the processor determines that both the maximum second state of charge and the minimum second state of charge are within the first SOC range, that is, the plurality of second states of charge corresponding to the plurality of battery cells satisfy the preset first SOC range, the processor performs step S3305.

At step S3305, if both the maximum second state of charge and the minimum second state of charge are within the first SOC range, the target amount of discharge of the battery pack within the preset period is acquired.

In the embodiment, if both the maximum second state of charge and the minimum second state of charge are within the first SOC range, that is, when $SOC_{2,max} \in [SOC_{CLA,min}, SOC_{CLA,max}]$ and $SOC_{2,min} \in [SOC_{CLA,min}, SOC_{CLA,max}]$, the processor acquires the target amount of discharge of the battery pack within the preset period. The preset period may be a default parameter in the processor, or may be adjusted dynamically by the processor depending on the actual operating condition of the vehicle.

As an example, the processor samples electric current of the battery pack within the preset period to obtain a plurality of current samples, calculates the mean current value of the plurality of current samples, and multiplies the mean current value by the duration corresponding to the preset period. The processor determines the result of the multiplication as the target amount of discharge of the battery pack within the preset period.

At step S3307, if the target amount of discharge is smaller than the specified discharge amount, it is determined that the charge information fails to satisfy the specified precision judging criteria.

The inventor came to the conclusion based on large quantities of test data of battery packs that if the target amount of discharge is greater than or equal to the specified discharge amount, the total state of charge of the battery pack calculated based on the second states of charge is more accurate. Otherwise, the total state of charge of the battery pack calculated based on the second states of charge is significantly deviated. Therefore, in the embodiment, when the target amount of discharge is smaller than the specified discharge amount, that is, $AH_{CAL} < Q_{CAL}$, the processor determines that the charge information fails to satisfy the specified precision judging criteria (i.e., the above-mentioned criterion 2). Here, $Q_{CAL}$ refers to the specified discharge amount, which may be a default parameter in the processor or may be adjusted dynamically by the processor depending on the actual operating condition of the vehicle. If the processor determines that the charge information fails to satisfy the specified precision judging criteria, it performs step S370. Otherwise, if the processor determines that the target amount of discharge is greater than or equal to the specified discharge amount, it performs step S3309.

At step S3309, if the target amount of discharge is greater than or equal to the specified discharge amount, the minimum first state of charge among the plurality of first states of charge corresponding to the plurality of battery cells is determined.

When the target amount of discharge is greater than or equal to the specified discharge amount, i.e., $AH_{CAL} \geq Q_{CAL}$, the processor determines the minimum first state of charge in the plurality of first states of charge corresponding to the plurality of battery cells. As an example, the processor sorts the plurality of first states of charge corresponding to the plurality of battery cells using a preset sort algorithm and determines the smallest one of the plurality of first states of charge as the minimum first state of charge. Specifically, the preset sort algorithm may be a selection sort algorithm, a bubble sort algorithm, or a sort-by-insertion algorithm, which will not be limited thereto.

At step S3311, if the minimum first state of charge is smaller than or equal to the upper limit of the first SOC range, it is determined that the charge information fails to satisfy the specified precision judging criteria.

The inventor came to the conclusion based on large quantities of test data of battery packs that if the plurality of first states of charge corresponding to the plurality of battery cells are greater than the plurality of second states of charge corresponding to the plurality of battery cells, the total state of charge of the battery pack calculated based on the second states of charge is more accurate. Otherwise, the total state of charge of the battery pack calculated based on the second states of charge is significantly deviated. Therefore, in the embodiment, if the minimum first state of charge is smaller than or equal to the upper limit of the first SOC range, that is, $SOC_{1,min} \leq SOC_{CLA,max}$, the processor determines that the charge information fails to satisfy the specified precision judging criteria (i.e., the above-mentioned criterion 3). Here, $SOC_{1,min}$ refers to the minimum first state of charge. If the processor determines that the charge information fails to satisfy the specified precision judging criteria, it performs step S370. Otherwise, if the processor determines that the minimum first state of charge is greater than the upper limit of the first SOC range, it performs step S3313.

At step S3313, if the minimum first state of charge is greater than the upper limit of the first SOC range, the difference between the minimum first state of charge and the maximum second state of charge is calculated.

If the minimum first state of charge is greater than the upper limit of the first SOC range, i.e., $SOC_{1,min} > SOC_{CLA,max}$, the processor calculates the difference between the minimum first state of charge and the maximum second state of charge, i.e., $SOC_{1,min} - SOC_{2,max}$.

At step S3315, if the difference is greater than or equal to a preset difference, it is determined that the charge information satisfies the specified precision judging criteria.

The inventor came to the conclusion based on large quantities of test data of battery packs when there is certain difference between the plurality of first states of charge corresponding to the plurality of battery cells and the plurality of second states of charge corresponding to the plurality of battery cells, the total state of charge of the battery pack calculated based on the second states of charge is more accurate. Otherwise, the total state of charge of the battery pack calculated based on the second states of charge is significantly deviated. Therefore, in the embodiment, if the difference is greater than or equal to a preset difference, that is, $SOC_{1,min} - SOC_{2,max} \geq \triangle SOC_{CLA}$, the processor determines that the charge information satisfies the specified precision judging criteria (i.e., the above-mentioned criteria 1 to 4). The preset difference may be a default parameter in the processor, or may be adjusted dynamically by the processor depending on the actual operating conditions of the vehicle. If the processor determines that the charge information satisfies the specified precision judging criteria, it performs step S350.

At step S3317, if the difference is smaller than the preset difference, it is determined that the charge information fails to satisfy the specified precision judging criteria.

If the difference is smaller than the preset difference, i.e., $SOC_{1,min} - SOC_{2,max} < \triangle SOC_{CLA}$, the processor determines that the charge information fails to satisfy the specified precision judging criteria (i.e., the above-mentioned criterion 4). When the processor determines that the charge information fails to satisfy the specified precision judging criteria, it performs step S370.

At step S350, if the charge information satisfies the specified precision judging criteria, the target state of charge of the battery cells is determined based on the second state of charge.

According to the embodiment, the target state of charge of the battery cells contains a maximum target state of charge and a minimum target state of charge. Specifically, if the processor determines that the charge information satisfies the specified precision judging criteria, it determines the maximum second state of charge as the maximum target state of charge and the minimum second state of charge as the minimum target state of charge. Subsequently, the processor may determine the total state of charge of the battery pack based on the maximum target state of charge and the minimum target state of charge. Alternatively, the processor may transmit the maximum target state of charge and the minimum target state of charge to a total state of charge calculation module to calculate the total state of charge of the battery pack.

At step S370, if the charge information fails to satisfy the specified precision judging criteria, the target state of charge of the battery cells is determined based on the first state of charge.

According to the embodiment, if the processor determines that the charge information fails to satisfy the specified precision judging criteria, it determines the maximum first state of charge and the minimum first state of charge among the plurality of first states of charge corresponding to the plurality of battery cells. As an example, the processor sorts the plurality of first states of charge of the plurality of battery cells using a preset sort algorithm and determines the greatest one of the plurality of first states of charge as the maximum first state of charge and the smallest one of the plurality of first states of charge as the minimum first state of charge. Specifically, the preset sort algorithm may be a selection sort algorithm, a bubble sort algorithm, or a sort-by-insertion algorithm, which will not be limited thereto. The processor further determines the maximum first state of charge as the maximum target state of charge and the minimum first state of charge as the minimum target state of charge. Similarly, the processor may further determine the total state of charge of the battery pack based on the maximum target state of charge and the minimum target state of charge. Alternatively, the processor may transmit the maximum target state of charge and the minimum target state of charge to the total state of charge calculation module to calculate the total state of charge of the battery pack.

In some embodiments, the processor is further applied in calculating the total state of charge of the battery pack. Therefore, it further includes step S390 after step S350 and step 370.

At step 390, the total state of charge of the battery pack is calculated using a preset weighting algorithm and based on the maximum target state of charge and the minimum target state of charge.

Specifically, the formula for calculating the total state of charge is as follows:

$$ SOC = k_1 * SOC_{max} + k_2 * SOC_{min} $$

wherein, SOC is the total state of charge of the battery pack, $SOC_{max}$ is the maximum target state of charge, $SOC_{min}$ is the minimum target state of charge, and $k_1$ and $k_2$ are weights respectively corresponding to $SOC_{max}$ and $SOC_{min}$. $k_1$ and $k_2$ may be default parameters in the processor, which may be adjusted dynamically by the processor according to the actual operating condition of the vehicle.

The present disclosure provides a method for calculating a state of charge. According to the embodiments, the precision criteria are described in detail, so that when the charge information satisfies the specified precision judging criteria, the total state of charge of the battery pack calculated based on the second states of charge is more accurate than that calculated based on the first states of charge. Thus, the vehicle can achieve a more accurate estimation of the total state of charge of the battery pack, thereby guaranteeing the driver's precise control over the real-time SOC of the battery pack while traveling and improving driving experience of the driver.

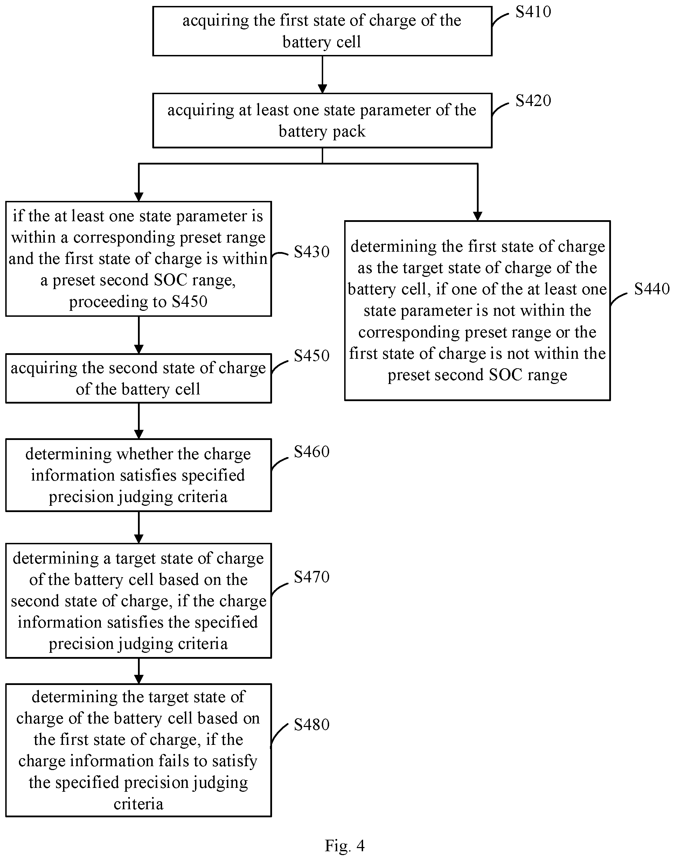

As shown in Fig. 4, Fig. 4 schematically shows the method for calculating a state of charge according to a third example of the present disclosure. The method is applied to a battery pack containing battery cells. Specifically, the method includes steps S410 to S480.

At step S410, a first state of charge of the battery cell is acquired.

Details of the implementation of step S410 can refer to the description of step S210 and will not be repeated.

At step S420, at least one state parameter of the battery pack is acquired.

The state parameter may include the state of health, the temperature, and the electric current of the battery pack and the voltage of the battery cells. Specifically, the temperature and the electric current of the battery pack and the voltage of the battery cells can be measured by detectors and obtained by the processor by reading the measured data. The state of health of the battery pack can be determined by the processor by reading a state of health indicator of the battery pack.

At step S430, if the at least one state parameter is within a corresponding preset range and the first state of charge is within a preset second SOC range, the second state of charge of the battery cell is acquired.

The inventor came to the conclusion based on large quantities of test data of battery packs that if the at least one parameter is within the preset range and the first state of charge is within the preset second SOC range, it means that the battery is in a good working condition. The second state of charge acquired at this time can be used to achieve a more accurate estimation of the total state of charge of the battery pack. Otherwise, the battery is in an abnormal state, resulting in significant deviation on the estimation of the second state of charge of the battery cells.

In some embodiments, the state parameter includes the state of health of the battery pack. The state of health indicator for the health state is a preset value, that is, if $St_{battery} \in \{St_{on,i}|i\}$, the processor determines that the state of health of the battery pack is within the corresponding preset range. $St_{battery}$ is a value of the state of health indicator, $St_{on,i}$ is preset values, and $i$ is the quantity of preset values.

In some embodiments, the state parameter includes the temperature of the battery pack. If the temperature of the battery pack is within a preset temperature range, i.e., $T_{current} \in [T_{on,min}, T_{on,max}]$, the processor determines that the temperature of the battery pack is within the corresponding preset range. $T_{current}$ is the temperature of the battery pack, $[T_{on,min}, T_{on,max}]$ is the preset temperature range. Specifically, the lower limit $T_{on,min}$ and the upper limit $T_{on,max}$ of the temperature range may be adjusted by the processor according to the actual operating condition of the vehicle.

In some embodiments, the state parameter includes the electric current of the battery pack. If the electric current of the battery pack is within a preset electric current range, i.e., $I_{current} \in [I_{on,min}, I_{on,max}]$, the processor determines that the electric current of the battery pack is within the corresponding preset range. $I_{current}$ is the electric current of the battery pack, $[I_{on,min}, I_{on,max}]$ is the preset electric current range. Specifically, the lower limit $I_{on,min}$ and the upper limit $I_{on,max}$ of the electric current range may be adjusted by the processor according to the actual operating condition of the vehicle. It should be noted that the electric current of the battery pack according to the present embodiment is a standing current. As an example, the processor samples of electric current of the battery pack within a specified period, acquiring multiple current samples. The processor performs filtering on the current samples, obtaining the standing current. Specifically, the filtering may be performed by a preset filter algorithm, which may be amplitude limiting filtering, median filtering, or mean filtering.

In some embodiments, the state parameter includes the voltage of the battery cells. If the voltage of the battery cells is within a preset voltage range, i.e., $U_{current} \in [U_{on,min}, U_{on,max}]$, the processor determines that the voltage of the battery cells is within the corresponding preset range. $U_{current}$ is the voltage of the battery cells and $[U_{on,min}, U_{on,max}]$ is the preset voltage range. Specifically, the lower limit $U_{on,min}$ and the upper limit $U_{on,max}$ of the voltage range may be adjusted by the processor according to the actual operating condition of the vehicle.

If the at least one parameter is within the preset range, the processor further determines whether the first state of charge is in the second SOC range. If so, the processor performs the steps for acquiring the second state of charge, i.e., steps S450 to S480.

The preset second SOC range can be a value range of values. If the value of the first state of charge is within the value range, it means that the first state of charge is within the preset second SOC range. Otherwise, if the value of the first state of charge is not within the value range, the first state of charge is not within the preset second SOC range. For example, the value range corresponding to the second SOC range may be [$SOC_{on,min}, SOC_{on,max}$], wherein the processor may adjust the lower limit $SOC_{on,min}$ and the upper limit $SOC_{on,max}$ dynamically based on the actual operating condition of the vehicle.

As an example, the processor determines the value range corresponding to the second SOC range by acquiring values of the operating condition indicator of the vehicle and based on a mapping table for the preset second SOC range. The mapping table for the preset second SOC range expresses the corresponding relation between values of the operating condition indicator and value ranges corresponding to second SOC ranges. Specifically, the mapping table for the preset second SOC range may be acquired by the R&D personnel based on large amount of test data of operating conditions of vehicles. The specific implementation of the mapping table of the preset second SOC range is not limited herein.

At step S440, if any state parameter is not within the corresponding preset range, or if the first state of charge is not within the preset second SOC range, the first state of charge is determined as the target state of charge of the battery cells.

If any of the state parameters is not within the corresponding preset range, i.e., $St_{battery} \notin \{St_{on,i}|i\}$, or $T_{current} \notin [T_{on,min}, T_{on,max}]$, or $I_{current} \notin [I_{on,min}, I_{on,max}]$, or $U_{current} \notin [U_{on,min}, U_{on,max}]$, or, if the first state of charge is not within the second SOC range, i.e., $SOC_1 \notin [SOC_{on,min}, SOC_{on,max}]$, the processor determines the first state of charge as the target state of charge of the battery cells. The targe state of charge is the basis for calculating the total state of charge of the battery pack. According to the embodiment, after the processor determines the first state of charge as the target state of charge, it performs steps S450 to S480.

According to the embodiment, the processor acquires the first state of charge of the battery cells and the at least one state parameter of the battery pack first, and then if it determines that the first state of charge of the battery cells or the at least one state parameter of the battery pack is not within the corresponding preset range, the processor will not perform the step of acquiring the second state of charge, thereby saving calculation resources for the processor.

At step S450, the second state of charge of the battery cells is acquired.

At step S460, a determination is made as to whether the charge information satisfies the specified precision judging criteria.

At step S470, if the charge information satisfies the specified precision judging criteria, the target state of charge is determined based on the second state of charge.

At step S480, if the charge information fails to satisfy the specified precision judging criteria, the target state of charge is determined based on the first state of charge.

The steps S450 to S480 are similar to steps S210 to S240 and details will not be repeated.

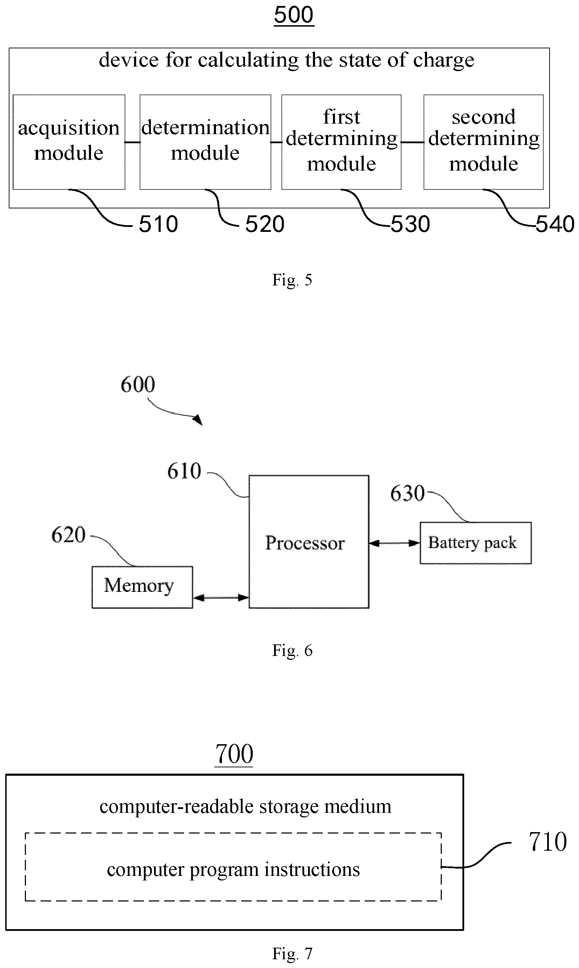

Referring to Fig. 5, Fig. 5 schematically shows a module block diagram of a device 500 for calculating the state of charge according to an example of the present disclosure. The device 500 is applied to a battery pack containing a battery cell. The device 500 comprises an acquisition module 510, a determination module 520, a first determining module 530, and a second determining module 540. The acquisition module 510 acquires charge information of the battery cell, which includes a first state of charge and a second state of charge of the battery cell, the first state of charge being determined based on a preset integration algorithm and the second state of charge being determined based on a preset filter algorithm. The determination module 520 is configured for determining whether the charge information satisfies specified precision judging criteria, which contains at least that the second state of charge satisfies a preset first SOC range, wherein when the charge information satisfies the specified precision judging criteria, the precision of the total state of charge of the battery pack calculated on the basis of the second state of charge is higher than that calculated on the basis of the first state of charge. The first determining module 530 is configured for determining the target state of charge of the battery cell based on the second state of charge if the charge information satisfies the specified precision judging criteria, the target state of charge being the basis for calculating the total state of charge of the battery pack. The second determining module 540 is configured for determining the target state of charge of the battery cell based on the first state of charge if the charge information fails to satisfy the specified judging precision criteria.

In an embodiment, a plurality of battery cells are provided. The determination module 520 is further configured for determining the maximum second state of charge and the minimum second state of charge in a plurality of second states of charge corresponding to the plurality of battery cells; and determining that the charge information fails to satisfy the specified precision judging criteria if the maximum second state of charge or the minimum second state of charge is not within the first SOC range.

In some embodiments, the determination module 520 is further configured for acquiring the target amount of discharge of the battery pack within the preset period if both the maximum second state of charge and the minimum second state of charge are within the first SOC range; and determining that the charge information fails to satisfy the specified precision judging criteria if the target amount of discharge is smaller than a specified discharge amount.

In some embodiments, the determination module 520 is further configured for determining the minimum first state of charge in a plurality of first states of charge corresponding to the plurality of battery cells if the target amount of discharge capacity is greater than or equal to the specified discharge amount; and determining that the charge information fails to satisfy the specified precision judging criteria if the minimum first state of charge is smaller than or equal to the upper limit of the first SOC range.

In some embodiments, the determination module 520 is further configured for calculating the difference between the minimum first state of charge and the maximum second state of charge if the minimum first state of charge is greater than the upper limit of the first SOC range; determining that the charge information satisfies the specified precision judging criteria if the difference is greater than or equal to the preset difference; and determining that the charge information fails to satisfy the specified precision judging criteria if the difference is smaller than the preset difference.

In some embodiments, the acquisition module 510 is further configured for acquiring the first state of charge of the battery cell and at least one state parameter of the battery pack, which includes the state of health, the temperature, and the electric current of the battery pack and the voltage of the battery cell. The acquisition module 510 is further configured for acquiring the second state of charge of the battery cell if the at least one state parameter is within a corresponding preset range and the first state of charge satisfies a preset second SOC range.

In some embodiments, if one of the at least one state parameter is not within the corresponding preset range or the first state of charge is not within the preset second SOC range, the second determining module 540 is further configured for determining the first state of charge as the target state of charge of the battery cell, wherein the target state of charge is the basis for calculating the total state of charge of the battery pack; and not performing the step of determining whether the charge information satisfies the specified precision judging criteria.

In some embodiments, the first determining module 530 is further configured for determining the maximum second state of charge as a maximum target state of charge and the minimum second state of charge as a minimum target state of charge. The second determining module 540 is further configured for determining the maximum first state of charge and the minimum first state of charge in the plurality of first states of charge corresponding to the plurality of battery cells; and determining the maximum first state of charge as the maximum target state of charge and the minimum first state of charge as the minimum target state of charge. The device 500 further comprises a total state of charge calculation module (not shown in the drawings) configured for calculating the total state of charge of the battery pack based on a preset weighting algorithm and based on the maximum target state of charge and the minimum target state of charge

Those skilled in the art can clearly understand that, for the convenience and brevity of description, the specific working process of the device and modules described above can refer to the corresponding process in the foregoing embodiments of the method, which will not be repeated here.

According to the embodiments of the present disclosure, the modules may be connected through coupling, such as electrical, mechanical or other forms of coupling.

In addition, the functional modules according to the embodiments of the present disclosure may be integrated into one processing module or physically separated, or two or more modules may be integrated in one module. The above-mentioned integrated module may be implemented in the form of hardware or software.

The present disclosure provides a device for calculating the state of charge. The device determines the first state of charge of the battery cells based on the preset integration algorithm and the second state of charge of the battery cells based on the preset filter algorithm, and then determines the second state of charge as the target state of charge of the battery cells if the charge information (i.e., the first state of charge and the second state of charge) satisfies the specified precision judging criteria, that is, calculating the total state of charge of the battery pack based on the second state of charged of the battery cells. If the charge information fails to satisfy the specified precision judging criteria, the device determines the first state of charge as the target state of charge of the battery cells.

If the charge information satisfies the specified precision judging criteria, the total state of charge of the battery pack calculated on the basis of the second state of charge is more accurate than that calculated on the basis of the first state of charge. Thus, the vehicle may achieve a more accurate estimation of the total state of charge of the battery pack, thereby guaranteeing a driver with a precise control in connection with the real-time SOC of the battery pack while traveling.

Referring to Fig. 6, Fig. 6 shows a vehicle 600 according to the present disclosure. The vehicle 600 comprises one or more processors 610, a memory 620, a battery pack 630, and one more application programs. The battery pack 630 contains a battery cell or cells. The one or more application programs are stored in the memory and configured to be executed by the one or more processors, and the one or more application programs are configured to perform the method according to the above-mentioned embodiments.

The processor 610 may comprise one or more processing cores. The processor 610 connects the various parts in the BMS via ports and wirings and performs functions of the BMS by operating or performing the instructions, programs, code set, or instruction set stored in the memory 620 and calling the data stored in the memory 620. Optionally, the processor 610 may be implemented as hardware, which may include at least one of the digital signal processing (DSP), the field-programmable gate array (FPGA), and the programmable logic array (PLA). The processor 610 can integrate one or more of a central processing unit 610 (CPU), a graphics processing unit 610 (GPU), and a modem. The CPU is mainly applied in processing the operating system, user interfaces, and application programs; the GPU is mainly applied in the rendering and drawing of the displayed content; and the modem is applied in wireless communication. It should be appreciated that the modem may not be integrated into the processor 610, and may be implemented in the form of a communication chip.

The memory 620 may include a random-access memory 620 (RAM), or a read-only memory 620 (ROM). The memory 620 can be used to store instructions, programs, code, code set, or instruction set. The memory 620 includes an application memory block and a data memory block, wherein, the application memory block is applied in implementing the instructions from the operating system, performing at least one function (such as, touch control, audio playing, and image playback), and executing the instructions from the methods according to the foregoing embodiments. The data memory block can store data generated during the use of the electronic equipment (for example, a phone directory, audio and video data, and chat history), etc.

The battery pack 630 has been described in detail in connection with the embodiments of the application environment and will not be repeated.

Referring to Fig. 7, an embodiment of the present disclosure further provides a computer-readable storage medium 700, which contains computer program instructions 710. The computer program instructions 710 can be executed by a processor to perform the method according to the foregoing embodiments.

The computer-readable storage medium 700 may include a flash memory, an electrically erasable programmable read-only memory (EEPROM), an electrical programmable read-only memory (EPROM), a hard disk drive, and a read-only memory (ROM). Optionally, the computer-readable storage medium contains a non-transitory computer-readable storage medium. The computer-readable storage medium 700 has memory space for the computer program instructions 710 for performing any steps of the above-mentioned method. The computer program instructions 710 can be read from one or more of computer program products or written into the one or more computer program products.

The above are only preferred embodiments of the present disclosure, but it should be appreciated that the above embodiments are not to be construed as limiting the present disclosure. Although the present disclosure has been described in detail with reference to the above embodiments, those skilled in the art should understand that they may make modifications to the technical solutions of the foregoing embodiments, or alter them without departing from the scope of the present disclosure. It is intended that the invention be construed as including all such modifications and alterations insofar as they come within the scope of the appended claims.

**Claims**

1. A method for calculating a state of charge, applied to a battery pack (110) comprising a battery cell (1120), comprising:

   acquiring charge information of the battery cell (1120) (S210, S310), the charge information containing a first state of charge and a second state of charge of the battery cell (1120), the first state of charge determined based on a preset integration algorithm and the second state of charge determined based on a preset filter algorithm;

determining whether the charge information satisfies specified precision judging criteria (S220), the specified precision judging criteria comprising at least that the second state of charge is within a preset first SOC range, wherein when the charge information satisfies the specified precision judging criteria, a total state of charge of the battery pack (110) calculated on the basis of the second state of charge is more accurate than that calculated on the basis of the first state of charge;

if the charge information satisfies the specified precision judging criteria, determining a target state of charge of the battery cell (1120) based on the second state of charge (S230, S350), the target state of charge being a basis for calculating the total state of charge of the battery pack (110); and

if the charge information fails to satisfy the specified precision judging criteria, determining the target state of charge of the battery cell (1120) based on the first state of charge (S240, S370), wherein the battery pack contains a plurality of battery cells (1120) **characterized in that** determining whether the charge information satisfies the specified precision judging criteria (S220) comprises:

   determining a maximum second state of charge and a minimum second state of charge in a plurality of second states of charge corresponding to the plurality of battery cells (1120) (S3301); and
   if the maximum second state of charge or the minimum second state of charge is not within the first SOC range, determining that the charge information fails to satisfy the specified precision judging criteria (S3303), wherein,
   determining whether the charge information satisfies the specified precision judging criteria (S220) further comprises:

      if both the maximum second state of charge and the minimum second state of charge are within the first SOC range, acquiring a target amount of discharge of the battery pack (110) within a preset period (S3305); and
      if the target amount of discharge is smaller than a specified discharge amount, determining that the charge information fails to satisfy the specified precision judging criteria (S3307).

2. The method according to claim 1, **characterized in that** determining whether the charge information satisfies the specified precision judging criteria (S220) further comprises:

   if the target amount of discharge is greater than the specified discharge amount, determining a minimum first state of charge in a plurality of first states of charge corresponding to the plurality of battery cells (1120) (S3309); and
   if the minimum first state of charge is smaller than or equal to an upper limit of the first SOC range, determining that the charge information fails to satisfy the specified precision judging criteria (S3311).

3. The method according to claim 2, **characterized in that** determining whether the charge information satisfies the specified precision judging criteria (S220) further comprises:

   if the minimum first state of charge is greater than the upper limit of the first SOC range, calculating a difference between the minimum first state of charge and the maximum second state of charge (S3313);
   if the difference is greater than or equal to a preset difference, determining that the charge information satisfies the specified precision judging criteria (S3315); and
   if the difference is smaller than the preset difference, determining that the charge information fails to satisfy the specified precision judging criteria (S3317).

4. The method according to any of claims 1-3, **characterized in that** acquiring the charge information of the battery cell (1120) (S210, S310) comprises:

   acquiring the first state of charge of the battery cell (1120) (S410);
   acquiring at least one state parameter of the battery pack (110) (S420), the at least one state parameter comprising state of health, temperature, and electric current of the battery pack (110), and voltage of the battery cell (1120); and
   if the at least one state parameter is within a corresponding preset range and the first state of charge is within a preset second SOC range, acquiring the second state of charge of the battery cell (1120) (S430).

5. The method according to claim 4, **characterized in that**,
   if one of the at least one state parameter is not within the corresponding preset range or the first state of charge is not within the preset second SOC range, determining the first state of charge as the target state of charge of the battery cell (1120), the target state of charge being the basis for calculating the total state of charge of the battery pack (110) (S440); and not performing the step of determining whether the charge information satisfies the specified precision judging criteria (S220).

6. The method according to any of claims 1-3, **characterized in that**,

   determining the target state of charge of the battery cell (1120) based on the second state of charge (S230, S350) comprises: determining the maximum second state of charge as a maximum target state of charge and determining the minimum second state of charge as a minimum target state of charge,
   determining the target state of charge of the battery cell (1120) based on the first state of charge (S240, S370) comprises:

      determining a maximum first state of charge and a minimum first state of charge in the plurality of first states of charge corresponding to the plurality of battery cells (1120); and
      determining the maximum first state of charge as the maximum target state of charge and determining the minimum first state of charge as the minimum target state of charge, and
      the method further comprises:
      calculating the total state of charge of the battery pack (110) using a preset weighting algorithm and based on the maximum target state of charge and the minimum target state of charge (S390).

7. A device (500) for calculating a state of charge of a battery pack (110) comprising a battery cell (1120), comprising:

   an acquisition module (510) configured for acquiring charge information of the battery cell (1120) (S210), the charge information comprising a first state of charge and a second state of charge of the battery cell (1120), the first state of charge determined based on a preset integration algorithm and the second state of charge determined based on a preset filter algorithm;
   a determination module (520) configured for determining whether the charge information satisfies specified precision judging criteria (S220), the specified precision judging criteria comprising at least that the second state of charge satisfies a preset first SOC range, wherein when the charge information satisfies the specified precision judging criteria, a total state of charge of the battery pack (110) calculated on the basis of the second state of charge is more accurate than that calculated on the basis of the first state of charge;

a first determining module (530) configured for determining a target state of charge of the battery cell (1120) based on the second state of charge if the charge information satisfies the specified precision judging criteria (S230), the target state of charge being a basis for calculating the total state of charge of the battery pack (110); and

a second determining module (540) configured for determining the target state of charge of the battery cell (1120) based on the first state of charge if the charge information fails to satisfy the specified precision judging criteria (S240), wherein the battery pack contains a plurality of battery cells (1120) **characterized in that** the determination module (520) is further configured for:

> determining a maximum second state of charge and a minimum second state of charge in a plurality of second states of charge corresponding to the plurality of battery cells (1120) (S3301); and
> if the maximum second state of charge or the minimum second state of charge is not within the first SOC range, determining that the charge information fails to satisfy the specified precision judging criteria (S3303), wherein,
> the determination module (520) is further configured for:
>
>> acquiring a target amount of discharge of the battery pack (110) within a preset period if both the maximum second state of charge and the minimum second state of charge are within the first SOC range (S3305); and
>> if a target amount of discharge is smaller than a specified discharge amount, determining that the charge information fails to satisfy the specified precision judging criteria (S3307).

8. The device (500) according to claim 7, **characterized in that** the determination module (520) is further configured for

> determining a minimum first state of charge in a plurality of first states of charge corresponding to the plurality of battery cells (1120) if the target amount of discharge is greater than or equal to the specified discharge amount (S3309); and
if the minimum first state of charge is smaller than or equal to an upper limit of the first SOC range, determining that the charge information fails to satisfy the specified precision judging criteria (S3311).

9. The device (500) according to claim 8, **characterized in that** the determination module (520) is further configured for:
calculating a difference between the minimum first state of charge and the maximum second state of charge if the minimum first state of charge is greater than the upper limit of the first SOC range (S3313), wherein:

> if the difference is greater than or equal to a preset difference, determining that the charge information satisfies the specified precision judging criteria (S3315); and
> if the difference is smaller than the preset difference, determining that the charge information fails to satisfy the specified precision judging criteria (S3317).

10. A vehicle (100, 600), **characterized in that** the vehicle (100, 600) comprises:

> a battery pack (110, 630) comprising battery cells (1120);
> one or more processors (120);
> a memory (620); and
> one or more application programs, wherein the one or more application programs are stored in the memory (620) and configured to be executed by the one or more processors (120), the one or more application programs configured to perform the method according to any of claims 1-6.

11. A computer-readable storage medium (700) having stored thereon computer program instructions (710) which, when executed by a processor (120), result in performance of the method according to any of claims 1-6.

**Patentansprüche**

1. Verfahren zum Berechnen eines Ladezustands, angewendet auf einen Akkupack (110), der eine Batteriezelle (1120) umfasst, das Folgendes beinhaltet:

> Erfassen von Ladeinformationen der Batteriezelle (1120) (S2l0, S3l0), wobei die Ladeinformationen einen ersten Ladezustand und einen zweiten Ladezustand der Batteriezelle (1120) enthalten, wobei der erste Ladezustand auf der Basis eines voreingestellten Integrationsalgorithmus bestimmt wird und der zweite Ladezustand auf der Basis eines voreingestellten Filteralgorithmus bestimmt wird;
Feststellen, ob die Ladeinformationen vorgegebene Präzisionsbeurteilungskriterien erfüllen (S220), wobei die vorgegebenen Präzisionsbeurteilungskriterien mindestens umfassen, dass der zweite Ladezustand innerhalb eines voreingestellten ersten SOC-(State of Charge)-Bereichs liegt, wobei, wenn die Ladeinformationen die vorgegebenen Präzisionsbeurteilungskriterien erfüllen, ein auf der Basis des zweiten Ladezustands berechneter Gesamtladezustand des Akkupacks (110) genauer ist als der auf der Basis des ersten Ladezustands berechnete;
Bestimmen, wenn die Ladeinformationen die vorgegebenen Präzisionsbeurteilungskriterien erfüllen, eines Soll-Ladezustands der Batteriezelle (1120) auf der Basis des zweiten Ladezustands (S230, S350), wobei der Soll-Ladezustand eine Basis für die Berechnung des Gesamtladezustands des Akkupacks (110) ist; und
Bestimmen, wenn die Ladeinformationen die vorgegebenen Präzisionsbeurteilungskriterien nicht erfüllen, des Soll-Ladezustands der Batteriezelle (1120) auf der Basis des ersten Ladezustands (S240, S370), wobei der Akkupack mehrere Batteriezellen (1120) enthält,
**dadurch gekennzeichnet, dass** das Feststellen, ob die Ladeinformationen die vorgegebenen Präzisionsbeurteilungskriterien erfüllen (S220), Folgendes beinhaltet:

Bestimmen eines maximalen zweiten Ladezustands und eines minimalen zweiten Ladezustands in mehreren zweiten Ladezuständen entsprechend den mehreren Batteriezellen (1120) (S3301); und
Feststellen, wenn der maximale zweite Ladezustand oder der minimale zweite Ladezustand nicht innerhalb des ersten SOC-Bereichs liegt, dass die Ladeinformationen die vorgegebenen Präzisionsbeurteilungskriterien nicht erfüllen (S3303),
wobei das Feststellen, ob die Ladeinformationen die vorgegebenen Präzisionsbeurteilungskriterien erfüllen (S220), ferner Folgendes beinhaltet:

Erfassen, wenn sowohl der maximale zweite Ladezustand als auch der minimale zweite Ladezustand innerhalb des ersten SOC-Bereichs liegen, einer Soll-Entladungsmenge des Akkupacks (110) innerhalb eines voreingestellten Zeitraums (S3305); und

Feststellen, wenn die Soll-Entladungsmenge kleiner als eine vorgegebene Entladungsmenge ist, dass die Ladeinformationen die vorgegebenen Präzisionsbeurteilungskriterien nicht erfüllen (S3307).

2. Verfahren nach Anspruch 1, **dadurch gekennzeichnet, dass** das Feststellen, ob die Ladeinformationen die vorgegebenen Präzisionsbeurteilungskriterien erfüllen (S220), ferner Folgendes beinhaltet:

Bestimmen, wenn die Soll-Entlademenge größer ist als die vorgegebene Entlademenge, eines minimalen ersten Ladezustands in mehreren ersten Ladezuständen entsprechend den mehreren Batteriezellen (1120) (S3309); und
Feststellen, wenn der minimale erste Ladezustand so groß wie oder kleiner als eine Obergrenze des ersten SOC-Bereichs ist, dass die Ladeinformationen die vorgegebenen Präzisionsbeurteilungskriterien nicht erfüllen (S3311).

3. Verfahren nach Anspruch 2, **dadurch gekennzeichnet, dass** das Feststellen, ob die Ladeinformationen die vorgegebenen Präzisionsbeurteilungskriterien erfüllen (S220), ferner Folgendes beinhaltet:

Berechnen, wenn der minimale erste Ladezustand höher als die Obergrenze des ersten SOC-Bereichs ist, einer Differenz zwischen dem minimalen ersten Ladezustand und dem maximalen zweiten Ladezustand (S3313);
Feststellen, wenn die Differenz so groß wie oder größer als eine voreingestellte Differenz ist, dass die Ladeinformationen die vorgegebenen Präzisionsbeurteilungskriterien erfüllen (S33l5); und
Feststellen, wenn die Differenz kleiner als die voreingestellte Differenz ist, dass die Ladeinformationen die vorgegebenen Präzisionsbeurteilungskriterien nicht erfüllen (S33l7).

4. Verfahren nach einem der Ansprüche 1-3, **dadurch gekennzeichnet, dass** das Erfassen der Ladeinformationen der Batteriezelle (1120) (S210, S310) Folgendes beinhaltet:

Erfassen des ersten Ladezustands der Batteriezelle (1120) (S410);
Erfassen mindestens eines Zustandsparameters des Akkupacks (110) (S420), wobei der mindestens eine Zustandsparameter Gesundheitszustand, Temperatur und elektrischen Strom des Akkupacks (110) sowie Spannung des Akkupacks (1120) umfasst; und
Erfassen, wenn der mindestens eine Zustandsparameter innerhalb eines entsprechenden voreingestellten Bereichs liegt und der erste Ladezustand innerhalb eines voreingestellten zweiten SOC-Bereichs liegt, des zweiten Ladezustands der Batteriezelle (1120) (S430).

5. Verfahren nach Anspruch 4, **gekennzeichnet durch**
Bestimmen, wenn einer der mindestens einen Zustandsparameter nicht innerhalb des entsprechenden voreingestellten Bereichs liegt oder der erste Ladezustand nicht innerhalb des voreingestellten zweiten SOC-Bereichs liegt, des ersten Ladezustands als den Soll-Ladezustand der Batteriezelle (1120), wobei der Soll-Ladezustand die Basis für die Berechnung des Gesamtladezustands des Akkupacks (110) (S440) ist; und Nichtdurchführen des Schrittes des Feststellens, ob die Ladeinformationen die vorgegebenen Präzisionsbeurteilungskriterien erfüllen (S220).

6. Verfahren nach einem der Ansprüche 1-3, **dadurch gekennzeichnet, dass**

das Bestimmen des Soll-Ladezustands der Batteriezelle (1120) auf der Basis des zweiten Ladezustands (S230, S350) Folgendes beinhaltet: Bestimmen des maximalen zweiten Ladezustands als maximalen Soll-Ladezustand und Bestimmen des minimalen zweiten Ladezustands als minimalen Soll-Ladezustand,
das Bestimmen des Soll-Ladezustands der Batteriezelle (1120) auf der Basis des ersten Ladezustands (S240, S370) Folgendes beinhaltet:

Bestimmen eines maximalen ersten Ladezustands und eines minimalen ersten Ladezustands in den mehreren ersten Ladezuständen entsprechend den mehreren Batteriezellen (1120); und
Bestimmen des maximalen ersten Ladezustands als maximalen Soll-Laezustand und Bestimmen des minimalen ersten Ladezustands als minimalen Soll-Ladezustand, und
das Verfahren ferner Folgendes beinhaltet: Berechnen des Gesamtladezustands des Akkupacks (110) mit Hilfe eines voreingestellten Gewichtungsalgorithmus und auf der Basis des maximalen Soll-Ladezustands und des minimalen Soll-Ladezustands (S390).

7. Gerät (500) zum Berechnen eines Ladezustands eines Akkupacks (110), das eine Batteriezelle (1120) umfasst, das Folgendes umfasst:

ein Erfassungsmodul (510), konfiguriert zum Erfassen von Ladeinformationen der Batteriezelle (1120) (S210), wobei die Ladeinformationen einen ersten Ladezustand und einen zweiten Ladezustand der Batteriezelle (1120) umfassen, wobei der erste Ladezustand auf der Basis eines voreingestellten Integrationsalgorithmus bestimmt wird und der zweite Ladezustand auf der Basis eines voreingestellten Filteralgorithmus bestimmt wird;
ein Feststellungsmodul (520), konfiguriert zum Feststellen, ob die Ladeinformationen vorgegebene Präzisionsbeurteilungskriterien erfüllen (S220), wobei die vorgegebenen Präzisionsbeurteilungskriterien zumindest umfassen, dass der zweite Ladezustand einen voreingestellten ersten SOC-Bereich erfüllt, wobei, wenn die Ladeinformationen die vorgegebenen Präzisionsbeurteilungskriterien erfüllen, ein auf der Basis des zweiten Ladezustands berechneter Gesamtladezustand des Akkupacks (110) genauer ist als der auf der Basis des ersten Ladezustands berechnete;
ein erstes Bestimmungsmodul (530), konfiguriert zum Bestimmen eines Soll-Ladezustands der Batteriezelle (1120) auf der Basis des zweiten Ladezustands, wenn die Ladeinformationen die vorgegebenen Präzisionsbeurteilungskriterien erfüllen (S230), wobei der Soll-Ladezustand eine Basis für die Berechnung des Gesamtladezustands des Batteriepacks (110) ist; und
ein zweites Bestimmungsmodul (540), konfiguriert zum Bestimmen des Soll-Ladezustands der Batteriezelle (1120) auf der Basis des ersten Ladezustands, wenn die Ladeinformationen die vorgegebenen Präzisionsbeurteilungskriterien nicht erfüllen (S240),
wobei der Akkupack mehrere Batteriezellen (1120) enthält, **dadurch gekennzeichnet, dass** das Feststellungsmodul (520) ferner konfiguriert ist zum:

Bestimmen eines maximalen zweiten Ladezustands und eines minimalen zweiten Ladezustands in mehreren zweiten Ladezuständen entsprechend den mehreren Batteriezellen (1120) (S3301); und
Feststellen, wenn der maximale zweite Ladezustand oder der minimale zweite Ladezustand nicht innerhalb des ersten SOC-Bereichs liegt, dass die Ladeinformationen die vorgegebenen Präzisionsbeurteilungskriterien nicht erfüllen (S3303), wobei das Feststellungsmodul (520) ferner konfiguriert ist zum:

Erfassen einer Soll-Entladungsmenge des Akkupacks (110) innerhalb eines voreingestellten Zeitraums, wenn sowohl der maximale zweite Ladezustand als auch der minimale zweite Ladezustand innerhalb des ersten SOC-Bereichs liegen (S3305); und Feststellen, wenn eine Soll-Entladungsmenge kleiner als eine vorgegebene Entladungsmenge ist, dass die Ladeinformationen die vorgegebenen Präzisionsbeurteilungskriterien nicht erfüllen (S3307).

8. Gerät (500) nach Anspruch 7, **dadurch gekennzeichnet, dass** das Feststellungsmodul (520) ferner konfiguriert ist zum:

Bestimmen eines minimalen ersten Ladezustands in mehreren ersten Ladezuständen entsprechend den mehreren Batteriezellen (1120), wenn die Soll-Entladungsmenge so groß wie oder größer als die vorgegebene Entladungsmenge (S3309) ist; und
Feststellen, wenn der minimale erste Ladezustand so groß wie oder kleiner als eine Obergrenze des ersten SOC-Bereichs ist, dass die Ladeinformationen die vorgegebenen Präzisionsbeurteilungskriterien nicht erfüllen (S3311).

9. Gerät (500) nach Anspruch 8, **dadurch gekennzeichnet, dass** das Feststellungsmodul (520) ferner konfiguriert ist zum:
Berechnen einer Differenz zwischen dem minimalen ersten Ladezustand und dem maximalen zweiten Ladezustand, wenn der minimale erste Ladezustand größer als die Obergrenze des ersten SOC-Bereichs (S3313) ist, wobei:

festgestellt wird, wenn die Differenz so groß wie oder größer als eine voreingestellte Differenz ist, dass die Ladeinformationen die vorgegebenen Präzisionsbeurteilungskriterien erfüllen (S3315); und
festgestellt wird, wenn die Differenz kleiner als die voreingestellte Differenz ist, dass die Ladeinformationen die vorgegebenen Präzisionsbeurteilungskriterien nicht erfüllen (S33l7).

10. Fahrzeug (100, 600), **dadurch gekennzeichnet, dass** das Fahrzeug (100, 600) Folgendes umfasst:

einen Akkupack (110, 630) mit Batteriezellen (1120);
einen oder mehrere Prozessoren (120);
einen Speicher (620); und
ein oder mehrere Anwendungsprogramme, wobei die ein oder mehreren Anwendungsprogramme in dem Speicher (620) gespeichert und zum Ausführen durch die ein oder mehreren Prozessoren (120) konfiguriert sind, wobei die ein oder mehreren Anwendungsprogramme zum Durchführen des Verfahrens nach einem der Ansprüche 1-6 konfiguriert sind.

11. Computerlesbares Speichermedium (700), auf dem Computerprogrammbefehle (710) gespeichert sind, die bei Ausführung durch einen Prozessor (120) zur Durchführung des Verfahrens nach einem der Ansprüche 1-6 führen.

## Revendications

1. Procédé de calcul d'un état de charge, appliqué à un bloc-batterie (110) comprenant une cellule de batterie (1120), comprenant :

une acquisition d'informations de charge de la cellule de batterie (1120) (S210, S310), les informations de charge contenant un premier état de charge et un second état de charge de la cellule de batterie (1120), le premier état de charge étant déterminé sur la base d'un algorithme d'intégration prédéfini et le second état de charge étant déterminé sur la base d'un algorithme de filtre prédéfini ;
une détermination du fait que les informations de charge satisfont ou non des critères d'appréciation de précision spécifiés (S220), les critères d'appréciation de précision spécifiés comprenant au moins le fait que le second état de charge se trouve dans une première plage de SOC prédéfinie, dans lequel lorsque les informations de charge satisfont les critères d'appréciation de précision spécifiés, un état de charge totale du bloc-batterie (110) calculé sur la base du second état de charge est plus précis que celui calculé sur la base du premier état de charge ;
si les informations de charge satisfont les critères d'appréciation de précision spécifiés, une détermination d'un état de charge cible de la cellule de batterie (1120) sur la base du second état de charge (S230, S350), l'état de charge cible étant une base pour un calcul de l'état de charge totale du bloc-batterie (110) ; et
si les informations de charge ne satisfont pas les critères d'appréciation de précision spécifiés, une détermination de l'état de charge cible de la cellule de batterie (1120) sur la base du premier état de charge (S240, S370),
dans lequel le bloc-batterie contient une pluralité de cellules de batterie (1120) **caractérisé en ce que** la détermination du fait que les informations de charge satisfont ou non les critères d'appréciation de précision spécifiés (S220) comprend :

une détermination d'un second état de charge maximum et d'un second état de charge minimum dans une pluralité de seconds états de charge correspondant à la pluralité de cellules de batterie (1120) (S3301) ; et

si le second état de charge maximum ou le second état de charge minimum n'est pas au sein de la première plage de SOC, une détermination du fait que les informations de charge ne satisfont pas les critères d'appréciation de précision spécifiés (S3303), dans lequel,

la détermination du fait que les informations de charge satisfont ou non les critères d'appréciation de précision spécifiés (S220) comprend en outre :

si le second état de charge maximum et le second état de charge minimum sont tous deux au sein de la première plage de SOC, une acquisition d'une quantité cible de décharge du bloc-batterie (110) au sein d'une période prédéfinie (S3305) ; et

si la quantité cible de décharge est inférieure à une quantité de décharge spécifiée, une détermination du fait que les informations de charge ne satisfont pas les critères d'appréciation de précision spécifiés (S3307).

2.   Procédé selon la revendication 1, **caractérisé en ce que** la détermination du fait que les informations de charge satisfont ou non les critères d'appréciation de précision spécifiés (S220) comprend en outre :

si la quantité de décharge cible est supérieure à la quantité de décharge spécifiée, une détermination d'un premier état de charge minimum dans une pluralité de premiers états de charge correspondant à la pluralité de cellules de batterie (1120) (S3309) ; et

si le premier état de charge minimum est inférieur ou égal à une limite supérieure de la première plage de SOC, une détermination du fait que les informations de charge ne satisfont pas les critères d'appréciation de précision spécifiés (S3311).

3.   Procédé selon la revendication 2, **caractérisé en ce que** la détermination du fait que les informations de charge satisfont ou non les critères d'appréciation de précision spécifiés (S220) comprend en outre :

si le premier état de charge minimum est supérieur à la limite supérieure de la première plage de SOC, un calcul d'un écart entre le premier état de charge minimum et le second état de charge maximum (S3313) ;

si l'écart est supérieur ou égal à un écart prédéfini, une détermination du fait que les informations de charge satisfont les critères d'appréciation de précision spécifiés (S3315) ; et

si l'écart est inférieur à l''écart prédéfini, une détermination du fait que les informations de charge ne satisfont pas les critères d'appréciation de précision spécifiés (S3317).

4.   Procédé selon l'une quelconque des revendications 1 à 3, **caractérisé en ce que** l'acquisition des informations de charge de la cellule de batterie (1120) (S210, S310) comprend :

une acquisition du premier état de charge de la cellule de batterie (1120) (S410) ;

une acquisition d'au moins un paramètre d'état du bloc-batterie (110) (S420), l'au moins un paramètre d'état comprenant un état de santé, une température, et un courant électrique du bloc-batterie (110), et une tension de la cellule de batterie (1120) ; et

si l'au moins un paramètre d'état est au sein d'une plage prédéfinie correspondante et le premier état de charge est au sein d'une seconde plage de SOC prédéfinie, une acquisition du second état de charge de la cellule de batterie (1120) (S430).

5.   Procédé selon la revendication 4, **caractérisé par** si un élément parmi l'au moins un paramètre d'état n'est pas au sein de la plage prédéfinie correspondante ou le premier état de charge n'est pas au sein de la seconde plage de SOC prédéfinie, une détermination du premier état de charge à titre d'état de charge cible de la cellule de batterie (1120), l'état de charge cible étant la base d'un calcul de l'état de charge totale du bloc-batterie (110) (S440) ; et une absence de réalisation de l'étape de détermination du fait que les informations de charge satisfont ou non les critères d'appréciation de précision spécifiés (S220).

6.   Procédé selon l'une quelconque des revendications 1 à 3, **caractérisé en ce que**

la détermination de l'état de charge cible de la cellule de batterie (1120) sur la base du second état de charge (S230, S350) comprend : une détermination du second état de charge maximum à titre d'état de charge cible maximum et une détermination du second état de charge minimum à titre d'état de charge cible minimum,

la détermination de l'état de charge cible de la cellule de batterie (1120) sur la base du premier état de charge (S240, S370) comprend :

une détermination d'un premier état de charge maximum et d'un premier état de charge minimum dans la pluralité de premiers états de charge correspondant à la pluralité de cellules de batterie (1120) ; et

une détermination du premier état de charge maximum à titre d'état de charge cible maximum et une détermination du premier état de charge minimum à titre d'état de charge cible minimum, et

le procédé comprend en outre :

un calcul de l'état de charge totale du bloc-batterie (110) à l'aide d'un algorithme de pondération prédéfini et sur la base de l'état de charge cible maximum et de l'état de charge cible minimum (S390).

7. Dispositif (500) de calcul d'un état de charge d'un bloc-batterie (110) comprenant une cellule de batterie (1120), comprenant :

un module d'acquisition (510) configuré pour acquérir des informations de charge de la cellule de batterie (1120) (S210), les informations de charge comprenant un premier état de charge et un second état de charge de la cellule de batterie (1120), le premier état de charge étant déterminé sur la base d'un algorithme d'intégration prédéfini et le second état de charge étant déterminé sur la base d'un algorithme de filtre prédéfini ;

un module de détermination (520) configuré pour déterminer le fait que les informations de charge satisfont ou non des critères d'appréciation de précision spécifiés (S220), les critères d'appréciation de précision spécifiés comprenant au moins le fait que le second état de charge satisfait une première plage de SOC prédéfinie, dans lequel lorsque les informations de charge satisfont les critères d'appréciation de précision spécifiés, un état de charge totale du bloc-batterie (110) calculé sur la base du second état de charge est plus précis que celui calculé sur la base du premier état de charge ;

un premier module de détermination (530) configuré pour une détermination d'un état de charge cible de la cellule de batterie (1120) sur la base du second état de charge si les informations de charge satisfont les critères d'appréciation de précision spécifiés (S230), l'état de charge cible étant une base pour un calcul de l'état de charge totale du bloc-batterie (110) ; et

un second module de détermination (540) configuré pour une détermination de l'état de charge cible de la cellule de batterie (1120) sur la base du premier état de charge si les informations de charge ne satisfont pas les critères d'appréciation de précision spécifiés (S240),

dans lequel le bloc-batterie contient une pluralité de cellules de batterie (1120) **caractérisé en ce que** le module de détermination (520) est en outre configuré pour :

une détermination d'un second état de charge maximum et d'un second état de charge minimum dans une pluralité de seconds états de charge correspondant à la pluralité de cellules de batterie (1120) (S3301) ; et

si le second état de charge maximum ou le second état de charge minimum n'est pas au sein de la première plage de SOC, une détermination du fait que les informations de charge ne satisfont pas les critères d'appréciation de précision spécifiés (S3303),

dans lequel

le module de détermination (520) est en outre configuré pour :

une acquisition d'une quantité cible de décharge du bloc-batterie (110) au sein d'une période prédéfinie si le second état de charge maximum et le second état de charge minimum sont tous deux au sein de la première plage de SOC (S3305) ; et

si une quantité cible de décharge est inférieure à une quantité de décharge spécifiée, une détermination du fait que les informations de charge ne satisfont pas les critères d'appréciation de précision spécifiés (S3307).

8. Dispositif (500) selon la revendication 7, **caractérisé en ce que** le module de détermination (520) est en outre configuré pour

une détermination d'un premier état de charge minimum dans une pluralité de premiers états de charge correspondant à la pluralité de cellules de batterie (1120) si la quantité cible de décharge est supérieure ou égale à la quantité de décharge spécifiée (S3309) ; et

si le premier état de charge minimum est inférieur ou égal à une limite supérieure de la première plage de SOC, une détermination du fait que les informations de charge ne satisfont pas les critères d'appréciation de précision spécifiés (S3311).

9. Dispositif (500) selon la revendication 8, **caractérisé en ce que** le module de détermination (520) est en outre configuré pour :

un calcul d'un écart entre le premier état de charge minimum et le second état de charge maximum si le premier état de charge minimum est supérieur à la limite supérieure de la première plage de SOC (S3313), dans lequel :

si l'écart est supérieur ou égal à un écart prédéfini, une détermination est faite que les informations de charge satisfont les critères d'appréciation de précision spécifiés (S3315) ; et
si l'écart est inférieur à l'écart prédéfini, une détermination est faite que les informations de charge ne satisfont pas les critères d'appréciation de précision spécifiés (S3317).

10. Véhicule (100, 600), **caractérisé en ce que** le véhicule (100, 600) comprend :

un bloc-batterie (110, 630) comprenant des cellules de batterie (1120) ;
un ou plusieurs processeurs (120) ;
une mémoire (620) ; et
un ou plusieurs programmes d'application, dans lequel les un ou plusieurs programmes d'application sont stockés dans la mémoire (620) et configurés pour être exécutés par les un ou plusieurs processeurs (120), les un ou plusieurs programmes d'application sont configurés pour réaliser le procédé selon l'une quelconque des revendications 1 à 6.

11. Support de stockage lisible par ordinateur (700) présentant stockées dessus des instructions de programme informatique (710), qui, lorsqu'elles sont exécutées par un processeur (120), conduisent à l'exécution du procédé selon l'une quelconque des revendications 1 à 6.

Fig. 1

| acquiring charge information of The battery cell | S210 |

| determining whether the charge information satisfies specified precision judging criteria | S220 |

| determining a target state of charge of the battery cell based on the second state of charge if the charge information satisfies the specified precision judging criteria | S230 |

| determining the target state of charge of the battery cell based on the first state of charge if the charge information fails to satisfy the specified precision judging criteria | S240 |

Fig. 2

acquiring charge information of a plurality of battery cells ⌐S310

determining a maximum and a minimum in a plurality of second states of charge corresponding to the plurality of battery cells ⌐S3301

acquiring a target amount of discharge of the battery pack within a preset period, if both the maximum second state of charge and the minimum second state of charge are within the first SOC range ⌐S3305

determining that the charge information fails to satisfy the specified precision judging criteria, if the maximum second state of charge or the minimum second state of charge is not within the first SOC range ⌐S3303

determining a minimum in a plurality of first states of charge corresponding to the plurality of battery cells, if the target amount of discharge is greater than the specified discharge amount ⌐S3309

determining that the charge information fails to satisfy the specified precision judging criteria, if the target amount of discharge is smaller than a specified discharge amount ⌐S3307

calculating a difference between the minimum first state of charge and the maximum second state of charge, if the minimum first state of charge is greater than the upper limit of the first SOC range ⌐S3313

determining that the charge information fails to satisfy the specified precision judging criteria, if the minimum first state of charge is smaller than or equal to an upper limit of the first SOC range ⌐S3311

determining that the charge information satisfies the specified precision judging criteria, if the difference is greater than or equal to a preset difference ⌐S3315

determining that the charge information fails to satisfy the specified precision judging criteria, if the difference is smaller than the preset difference ⌐S3317

determining a target state of charge of the battery cell based on the second state of charge, if the charge information satisfies the specified precision judging criteria ⌐S350

determining the target state of charge of the battery cell based on the first state of charge, if the charge information fails to satisfy the specified precision judging criteria ⌐S370

calculating the total state of charge of the battery pack using a preset weighting algorithm and based on the maximum target state of charge and the minimum target state of charge ⌐S390

Fig. 3

```
         ┌─────────────────────────────────────┐
         │  acquiring the first state of charge │    S410
         │          of the battery cell          │
         └─────────────────────────────────────┘
                          │
                          ▼
         ┌─────────────────────────────────────┐
         │  acquiring at least one state         │    S420
         │  parameter of the battery pack        │
         └─────────────────────────────────────┘
              │                        │
              ▼                        ▼
┌──────────────────────────┐  ┌──────────────────────────────┐
│ if the at least one state│  │ determining the first state   │
│ parameter is within a    │  │ of charge as the target state │
│ corresponding preset     │S430│ of charge of the            │   S440
│ range and the first state│  │ battery cell, if one of the   │
│ of charge is within      │  │ at least one state parameter  │
│ a preset second SOC      │  │ is not within the             │
│ range, proceeding to S450│  │ corresponding preset range or │
└──────────────────────────┘  │ the first state of charge is  │
              │               │ not within the preset second  │
              ▼               │ SOC range                     │
┌──────────────────────────┐  └──────────────────────────────┘
│ acquiring the second     │ S450
│ state of charge of the   │
│ battery cell             │
└──────────────────────────┘
              │
              ▼
┌──────────────────────────┐
│ determining whether the  │ S460
│ charge information        │
│ satisfies specified      │
│ precision judging criteria│
└──────────────────────────┘
              │
              ▼
┌──────────────────────────┐
│ determining a target     │
│ state of charge of the   │ S470
│ battery cell based on the│
│ second state of charge,  │
│ if the charge            │
│ information satisfies the │
│ specified precision      │
│ judging criteria         │
└──────────────────────────┘
              │
              ▼
┌──────────────────────────┐
│ determining the target   │
│ state of charge of the   │ S480
│ battery cell based on the│
│ first state of charge, if│
│ the charge information    │
│ fails to satisfy the     │
│ specified precision      │
│ judging criteria         │
└──────────────────────────┘
```

Fig. 4

## 500

| device for calculating the state of charge |||| |
|---|---|---|---|
| acquisition module | determination module | first determining module | second determining module |

510　　520　　530　　540

Fig. 5

600

620 ── Memory　610 ── Processor ←→ 630 ── Battery pack

Fig. 6

## 700

| computer-readable storage medium |
|---|
| computer program instructions |

710

Fig. 7

**EP 4 332 595 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3828568 A1